# EUROPEAN PATENT APPLICATION

(11) **EP 4 194 495 A1**
(43) Date of publication of application: **14.06.2023**
(21) Application number: 21854456.7
(22) Date of filing: 02.06.2021
(51) Int. Cl.: C08K 7/00, C08L 101/00, C08L 63/00, H01B 1/22, H01L 21/52, C08K 3/08

(54) **CONDUCTIVE COMPOSITION, DIE ATTACHMENT MATERIAL, PRESSURE-SINTERED DIE ATTACHEMENT MATERIAL, AND ELECTRONIC COMPONENT**

(30) Priority: 04.08.2020 JP 2020132286
(71) Applicant: Namics Corporation, Niigata-shi, Niigata 950-3131 (JP)
(72) Inventor: SASAKI, Koji, Niigata-shi, Niigata 950-3131 (JP)
(74) Representative: Mathys & Squire
(86) International application number: PCT/JP2021/020998
(87) International publication number: WO 2022/030089

(57) **Abstract**

Provided is a conductive composition capable of achieving excellent die shear strength by sintering silver particles together even by heat treatment at a low temperature or for a short period of time regardless of whether pressure is applied or not. The conductive composition contains silver particles (A) having an average particle size of 0.05 to 5 µm, a solvent (B), and a thermosetting resin (C). Easily saponifiable chlorine concentration of the thermosetting resin (C) is 3,000 to 12,000 ppm. The conductive composition contains 0.1 to 1.5 parts by mass of the thermosetting resin (C) based on 100 parts by mass of the silver particles (A).

## Description

### TECHNICAL FIELD

The present invention relates to a conductive composition, a die attachment material, a pressure-sintered die attachment material, and an electronic component. More specifically, the present invention relates to a conductive composition capable of achieving excellent die shear strength by sintering silver particles together even by heat treatment at a low temperature or for a short period of time, and to a die attachment material, a pressure-sintered die attachment material, and an electronic component, containing such a conductive composition.

### BACKGROUND ART

In recent years, from the viewpoint of productivity, as a material such as a die attachment material used for adhesion of members in semiconductor devices, electric components, and electronic components, there is a demand for a conductive composition having sufficient conductivity by sintering the silver particles together even by the heat treatment at a low temperature or for a short period of time, regardless of whether pressure is applied or not.

As a technique related to the adhesion of the members in the semiconductor device, for example, a method including placing the die attachment material between a substrate and a semiconductor element and bonding the semiconductor element to the substrate by heating the semiconductor element and the substrate has been proposed (see, for example, PATENT LITERATURE 1).

For example, PATENT LITERATURE 1 discloses a method of bonding the semiconductor element to the substrate by the following three steps. In a first step, the substrate and the semiconductor element are arranged such that silver or silver oxide applied to a surface of the substrate is in contact with silver or silver oxide applied to a surface of the semiconductor element. In a second step, the semiconductor element and the substrate are temporarily bonded by pressure or ultrasonic vibration applied to the semiconductor element or the substrate. Then, in a third step, the semiconductor element and the substrate are permanently bonded by applying a temperature of 150°C to 900°C to the semiconductor element and the substrate.

### CITATION LIST

### PATENT LITERATURE

PATENT LITERATURE 1: WO 2010/084742 A

### SUMMARY OF INVENTION

### PROBLEMS TO BE SOLVED BY INVENTION

However, a conventional conductive composition such as a die attachment material has a problem that it is difficult to achieve sufficient die shear strength by the heat treatment at a low temperature or for a short period of time. For example, in Example 14 of PATENT LITERATURE 1, a substrate to which a semiconductor light emitting element is temporarily bonded is permanently bonded by heating at about 320°C for about 30 minutes in a nitrogen stream. Such a conductive composition has a problem that it takes a long time for bonding, and it cannot be said that it is sufficient to achieve both sintering at a low temperature or for a short period of time and die shear strength.

The present invention has been made in view of such problems of the related art. The present invention provides a conductive composition capable of achieving excellent die shear strength by sintering the silver particles together even by the heat treatment at a low temperature or for a short period of time, regardless of whether the pressure is applied or not. In addition, the present invention also provides a die attachment material, a pressure-sintered die attachment material, and an electronic component that achieve excellent die shear strength by containing the conductive composition described above.

### SOLUTION TO PROBLEMS

The present invention provides a conductive composition, a die attachment material, a pressure-sintered die attachment material, and an electronic component described below.
[1] A conductive composition containing silver particles (A) having an average particle size of 0.05 to 5 µm, a solvent (B), and a thermosetting resin (C), wherein
   easily saponifiable chlorine concentration of the thermosetting resin (C) is 3,000 to 12,000 ppm, and
   the conductive composition contains 0.1 to 1.5 parts by mass of the thermosetting resin (C) based on 100 parts by mass of the silver particles (A).
[2] The conductive composition according to the above-described [1], wherein the thermosetting resin (C) contains an epoxy resin.
[3] The conductive composition according to the above-described [1] or [2], wherein the silver particles (A) contain fine silver particles having an average particle size of 0.05 to 0.5 µm.
[4] A die attachment material containing the conductive composition according to any one of the above-described [1] to [3].
[5] A pressure-sintered die attachment material containing the conductive composition according to any one of the above-described [1] to [3].
[6] An electronic component including a sintered body of the conductive composition according to any one of the above-described [1] to [3].

### EFFECTS OF INVENTION

In the conductive composition of the present invention, the silver particles are sintered together even by the heat treatment at a low temperature or for a short period of time regardless of whether the pressure is applied or not. Therefore, the conductive composition has an effect of being able to achieve excellent die shear strength.
Further, the die attachment material, the pressure-sintered die attachment material, and the electronic component of the present invention contain the conductive composition of the present invention described above. Therefore, these materials and component have an effect of having excellent die shear strength.

### DESCRIPTION OF EMBODIMENTS

Hereinafter, embodiments of the present invention will be described. However, the present invention is not limited to the following embodiments.
Therefore, it should be understood that appropriate modifications and improvements to the following embodiments based on the common knowledge of those skilled in the art, without departing from the gist of the present invention, also fall within the scope of the present invention.

### [Conductive composition]

An embodiment of a conductive composition of the present invention is a conductive composition containing silver particles (A) having an average particle size of 0.05 to 5 µm, a solvent (B), and a thermosetting resin (C). The conductive composition of the present embodiment is a material such as a die attachment material used for adhesion of members in semiconductor devices, electric components, and electronic components. Hereinafter, the "silver particles (A) having an average particle size of 0.05 to 5 µm" may be simply referred to as the "silver particles (A)".

Easily saponifiable chlorine concentration of the thermosetting resin (C) of the conductive composition of the present embodiment is 3,000 to 12,000 ppm. Further, the conductive composition contains 0.1 to 1.5 parts by mass of the thermosetting resin (C) based on 100 parts by mass of the silver particles (A). With the conductive composition formed in this manner, the silver particles may be sintered together through heat treatment even at a low temperature or for a short period of time, regardless of whether pressure is applied or not, to achieve the excellent die shear strength. Components forming the conductive composition of the present embodiment will be described in more detail below.

### [Silver particles (A)]

The silver particles (A) are particles containing silver (Ag) or a silver alloy. The shape of the silver particles (A) is not particularly limited. The shape of the silver particles may be any shape, for example, spherical, flake-like, scaly, needle-like, and the like. As the silver particles (A), silver particles containing mixed silver particles of different shapes may be used. Note that many silver particles (Ag particles) may be called silver powder (Ag powder). The same applies to other particles.

The average particle size of the silver particles (A) is preferably 0.05 to 5 µm. From the viewpoint of sinterability, the silver particles (A) more preferably have an average particle size of 1.5 µm or less. Note that in the present specification, the silver particles and fine silver particles may be used in the form of primary particles. Alternatively, the silver particles and the fine silver particles may be used in the form of secondary particles, or may be used in the form of a mixture of the primary particles and the secondary particles. When the primary particles are used, the average particle size can be measured as an average value of particle size (a number average value) when 200 primary particles are observed with a scanning electron microscope (SEM). When the secondary particles are used, the average particle size can be measured as an average value of particle size (a number average value) when 200 secondary particles are observed with the scanning electron microscope (SEM). When the primary particles and the secondary particles are mixed, the average particle size can be measured as an average value of particle size (a number average value) when a total of 200 primary particles and secondary particles are observed with the scanning electron microscope (SEM). As a magnification of the SEM when observing with the SEM, a suitable size for observing the silver particles and the fine silver particles can be appropriately selected. A magnification of 3,000 to 50,000 times is usually used. Note that the primary particles and the secondary particles are defined based on the description of JIS H7008 (ultrafine metal particles).

A method for preparing silver particles (A) is not particularly limited. For example, the silver particles (A) can be prepared by a reduction method, a pulverization method, an electrolytic method, an atomization method, a heat treatment method, or a combination thereof.

The silver particles (A) may contain fine silver particles (a) having an average particle size of 1 µm or less. By containing the fine silver particles (a), the die shear strength can be further increased.

The average particle size of the fine silver particles (a) is preferably 0.05 to 0.5 µm, more preferably 0.05 to 0.4 µm, still more preferably 0.05 to 0.2 µm. Note that the fine silver particles (a) are usually substantially spherical. When the average particle size of the fine silver particles (a) is within the above range, aggregation of the fine silver particles (a) and the silver particles (A) containing the fine silver particles (a) is suppressed. Therefore, it is easy to obtain storage stability.

A crystallite size of the fine silver particles (a) is preferably 20 to 70 nm, and more preferably 20 to 50 nm. When the crystallite size is within this range, volume shrinkage during firing is suppressed. At the same time, denseness and surface smoothness of an adhesive portion formed after firing are ensured.

A ratio (average particle size/crystallite size) of the average particle size to the crystallite size of the fine silver particles (a) is preferably in a range of 1.5 to 5, more preferably 1.5 to 4, and still more preferably 1.5 to 3. When the above ratio is within this range, an adhesive portion exhibiting sufficient conductivity can be formed, for example, at a firing temperature of 200°C or less.

As the fine silver particles (a), fine silver particles deposited by a reduction reaction of a silver carboxylate treated with a primary amine can be used. Alternatively, fine silver particles coated or treated with organic matter can be used. Examples of the former include fine silver particles disclosed in JP-A-2006-183072 and JP-A-2011-153362. Examples of the latter include fine silver particles disclosed in JP-A-2009-289745 and JP-A-2010-065277. Moreover, as the fine silver particles (a), fine silver particles disclosed in WO 2017/169534 A and the like can also be used. The fine silver particles (a) are nano-order. That is, the fine silver particles (a) have a large total surface area per unit weight. Further, the fine silver particles (a) also have a high surface energy. Therefore, in addition to inherently good sinterability, during sintering, for example, volatilization, thermal decomposition, or elution into a solvent of organic matter on a surface of the fine silver particles (a) occurs. As a result, a surface of silver is exposed, and the fine silver particles (a) come into direct contact with each other. Therefore, sintering proceeds easily.

Specifically, in preparation of the fine silver particles (a), the silver salt of the carboxylic acid and an aliphatic primary amine are mixed. Then, after a reducing agent is added, the fine silver particles (a) are deposited at a reaction temperature of 20°C to 80°C. Thus, the fine silver particles (a) can be prepared.

The silver salt of the carboxylic acid is not particularly limited. The silver salt of the carboxylic acid may be a silver salt of either aliphatic or aromatic carboxylic acid. Further, the silver salt of the carboxylic acid may be a silver salt of a monocarboxylic acid or a silver salt of a polyvalent carboxylic acid such as dicarboxylic acid. The silver salt of the aliphatic carboxylic acid may be a silver salt of a chain aliphatic carboxylic acid or a silver salt of a cycloaliphatic carboxylic acid. The silver salt of the carboxylic acid is preferably a silver salt of an aliphatic monocarboxylic acid, more preferably a silver salt of a chain aliphatic monocarboxylic acid, still more preferably silver acetate, silver propionate, or silver butyrate, and particularly preferably silver acetate. These silver salts of the carboxylic acids can be used alone. Alternatively, two or more of the silver salts of the carboxylic acids can be used in combination.

The aliphatic primary amine is not particularly limited. The aliphatic primary amine may be a chain aliphatic primary amine or a cycloaliphatic primary amine. Further, the aliphatic primary amine may be a monoamine compound or a polyamine compound such as a diamine compound. The aliphatic primary amine also includes a primary amine having an aliphatic hydrocarbon group substituted with an alkoxy group such as hydroxyl group, methoxy group, ethoxy group, or propyl group. More preferred aliphatic primary amines are 3-methoxypropylamine, 3-aminopropanol, and 1,2-diaminocyclohexane. These aliphatic primary amines can be used alone. Alternatively, two or more of the aliphatic primary amines can be used in combination.

An amount of the aliphatic primary amine to be used is determined according to requirements or apparatuses on processes such as post-processing of the fine silver particles (a) to be prepared. From the viewpoint of obtaining fine silver particles with a controlled particle size, 1 equivalent or more of the aliphatic primary amine is preferably used based on 1 equivalent of the silver salt of the carboxylic acid. Considering effects of excessive aliphatic primary amines on the environment and the like, the amount of the aliphatic primary amine to be used is preferably 1.0 to 3.0 equivalents, more preferably 1.0 to 1.5 equivalents, particularly preferably 1.0 to 1.1 equivalents based on 1 equivalent of the silver salt of the carboxylic acid. For example, the excessive aliphatic primary amines may be vaporized upon heating. Therefore, it is desirable to adopt the above-described preferred use amount range.

Mixing of the silver salt of the carboxylic acid and the aliphatic primary amine can be carried out in the presence or absence of an organic solvent. From the viewpoint of ease of mixing, mixing in the presence of the organic solvent is preferred. Examples of the organic solvent include alcohols such as ethanol, propanol, and butanol, ethers such as propylene glycol dibutyl ether, and aromatic hydrocarbons such as toluene. These organic solvents can be used alone. Alternatively, two or more of the organic solvents can be used in combination. An amount of the organic solvent to be used can be set to any amount from the viewpoint of convenience of mixing, and productivity of the fine silver particles (a) in subsequent steps.

The silver salt of the carboxylic acid and the aliphatic primary amine can be mixed, for example, by adding the silver salt of the carboxylic acid to the primary aliphatic amine or a mixture of the primary aliphatic amine and the organic solvent, which is being stirred. Stirring can be continued as appropriate even after addition is completed. Meanwhile, the temperature is preferably maintained at 20°C to 80°C. A more preferred temperature is 20°C to 60°C.

The reducing agent is then added. Thus, the fine silver particles (a) are deposited. From the viewpoint of reaction control, the reducing agent is preferably formic acid, formaldehyde, ascorbic acid, or hydrazine, and more preferably formic acid. These reducing agents can be used alone. Alternatively, two or more of the reducing agents can be used in combination.

An amount of the reducing agent to be used is usually at least a redox equivalent to the silver salt of the carboxylic acid. The redox equivalent is preferably 0.5 to 5 times, and more preferably 1 to 3 times. When the silver salt of the carboxylic acid is the silver salt of the monocarboxylic acid and the formic acid is used as the reducing agent, an amount of formic acid to be used in terms of moles is preferably 0.5 to 1.5 mol, more preferably 0.5 to 1.0 mol, and still more preferably 0.5 to 0.75 mol based on 1 mol of the silver salt of the carboxylic acid.

The temperature is preferably maintained at 20°C to 80°C during addition of the reducing agent and subsequent reaction. The temperature during the addition of the reducing agent and the subsequent reaction is more preferably 20°C to 70°C, and still more preferably 20°C to 60°C. When the temperature is within this range, particle growth of the fine silver particles (a) is sufficient. Therefore, the productivity is high. Further, secondary aggregation is also suppressed. A time required for the addition of the reducing agent and the subsequent reaction is usually 10 minutes to 10 hours, although it depends on a scale of a reactor. During the addition of the reducing agent and the subsequent reaction, the organic solvents such as alcohols such as ethanol, propanol, and butanol, ethers such as propylene glycol dibutyl ether, and aromatic hydrocarbons such as toluene can be additionally added as needed.

During the addition of the reducing agent and the subsequent reaction, an amount (mol) of the silver salt of the carboxylic acid based on a total volume (L) of a mixed solution containing the silver salt of the carboxylic acid and the aliphatic primary amine, the reducing agent, and an optional organic solvent is preferably set in a range of 1.0 to 6.0 mol/L, more preferably 2.0 to 5.0 mol/L, and still more preferably 2.0 to 4.0 mol/L. When the concentration is within this range, reaction solution is sufficiently stirred. As a result, heat of reaction can be removed. Therefore, the average particle size of the fine silver particles (a) to be deposited is appropriate. Eventually, there is no hindrance to operations such as sedimentation decantation and solvent replacement in the subsequent steps.

The reducing agent can be continuously fed to a solution containing a mixture of the silver salt of the carboxylic acid and the aliphatic primary amine, and an arbitrary organic solvent, which have been charged in a reaction vessel. When the reaction is carried out in such a semi-batch manner, an amount of deposition of the fine silver particles (a) per hour from start of addition of the reducing agent to end of the reaction can be set in a range of 0.3 to 1.0 mol/h/L based on 1 L of total volume of a solution containing mixture of the silver salt of the carboxylic acid and the aliphatic primary amine, the reducing agent, and the optional organic solvent. Therefore, the productivity is very high. Greater productivity can be obtained when the reaction is carried out in a continuous reaction system (a continuous complete mixing tank or a flow system). Therefore, there is significant benefit for industrial implementation.

The fine silver particles (a) thus obtained have a narrow particle size distribution. Geometric standard deviation of the fine silver particles can be 2.0 or less. In the present specification, the geometric standard deviation refers to a ratio (D84.3 value/D50 value) of 84.3% particle size (D84.3 value) to 50% particle size (D50 value) based on number. These particle sizes are obtained by laser diffraction scattering particle size distribution measurement.

After the fine silver particles (a) deposited by the reaction are sedimented, the fine silver particles (a) can be separated by removing supernatant by decantation or the like. Alternatively, by adding a solvent such as alcohols such as methanol, ethanol, or terpineol, the fine silver particles (a) can be separated. A layer containing the fine silver particles can be directly used in a state containing the solvent.

As an alternative way, the fine silver particles (a) can be obtained by coating, with organic matter, the fine silver particles produced by the reduction method, the pulverization method, the electrolytic method, the atomization method, the heat treatment method, or a combination thereof. From the viewpoint of low-temperature sinterability, the fine silver particles (a) produced by the reduction method are preferably coated with organic matter.

Examples of the organic matter include higher and intermediate fatty acids and derivatives thereof. Examples of the derivatives include metal salts of the higher and intermediate fatty acids, higher and intermediate fatty acid amides, higher and intermediate fatty acid esters, and higher and intermediate alkylamines. Among them, the higher and intermediate fatty acids are preferred.

The higher fatty acid is a fatty acid having 15 or more carbon atoms. Examples of the higher fatty acids include linear saturated fatty acids such as pentadecanoic acid, hexadecanoic acid (palmitic acid), heptadecanoic acid, octadecanoic acid (stearic acid), 12-hydroxyoctadecanoic acid (12-hydroxystearic acid), eicosanoic acid (arachidic acid), docosanoic acid (behenic acid), tetracosanoic acid (lignoceric acid), hexacosanoic acid (cerotic acid), and octacosanoic acid (montanic acid), branched saturated fatty acids such as 2-pentylnonanoic acid, 2-hexyldecanoic acid, 2-heptyldodecanoic acid, and isostearic acid, and unsaturated fatty acids such as palmitoleic acid, oleic acid, isooleic acid, elaidic acid, linoleic acid, linolenic acid, ricinoleic acid, gadrenic acid, erucic acid, and ceracoleic acid.

The intermediate fatty acid is a fatty acid having 6 to 14 carbon atoms. Examples of the intermediate fatty acids include linear saturated fatty acids such as hexanoic acid (caproic acid), heptanoic acid, octanoic acid (caprylic acid), nonanoic acid (pelargonic acid), decanoic acid (capric acid), undecanoic acid, dodecanoic acid (lauric acid), tridecanoic acid, and tetradecanoic acid (myristic acid), branched saturated fatty acids such as isohexanoic acid, isoheptanoic acid, 2-ethylhexanoic acid, isooctanoic acid, isononanoic acid, 2-propylheptanoic acid, isodecanoic acid, isoundecanoic acid, 2-butyloctanoic acid, isododecanoic acid, and isotridecanoic acid, and unsaturated fatty acids such as 10-undecenoic acid.

It is also possible to use the fine silver particles (a) obtained by substituting the fine silver particles (a) coated with a higher fatty acid or a derivative thereof with a lower fatty acid. The fine silver particles coated with a fatty acid having 12 to 18 carbon atoms are preferred from the viewpoint of sinterability and dispersion stability of the fine silver particles (a). The fine silver particles (a) can be used alone. Alternatively, two or more of the fine silver particles (a) may be used in combination.

The fine silver particles (a) are preferably sintered when held in the conductive composition under a temperature condition of 180°C to 250°C for 20 minutes to 2 hours. The fine silver particles (a) in the conductive composition are more preferably sintered when held under the temperature condition of 190°C to 220°C for 20 minutes to 2 hours. The fine silver particles (a) in the conductive composition are more preferably sintered when held under the temperature condition of 195°C to 210°C for 20 minutes to 2 hours. When the fine silver particles (a) in the conductive composition can be sintered under the above conditions, the fine silver particles (a) contained in the conductive composition can form a bonding portion exhibiting sufficient conductivity, for example, at a firing temperature of 200°C or less. Whether the fine silver particles (a) in the conductive composition are sintered alone when the fine silver particles (a) are held under the temperature condition of 180°C to 250°C for 20 minutes to 2 hours is checked by, for example, a field emission scanning electron microscope (JSM7500F (product name) manufactured by JEOL Ltd.).

The content of the silver particles (A) in the conductive composition is not particularly limited. From the viewpoint of ensuring sufficient thermal conductivity, the content is preferably 75 to 93 mass%, more preferably 80 to 93 mass%, still more preferably 85 to 93 mass %, and particularly preferably 90 to 93 mass % in terms of silver based on the entire conductive resin composition (100 mass%). Note that regarding the mass of the silver particles (A) in the conductive resin composition, a residual amount when the conductive resin composition is heated at 800°C for 5 minutes is defined as 100 mass%.

In addition, the conductive composition of the present embodiment can be suitably used as the die attachment material. In such a die attachment material, the silver particles are sintered together even by the heat treatment at a low temperature or for a short period of time regardless of whether the pressure is applied or not in a bonding process. As a result, excellent die shear strength can be achieved. When the die attachment material is sintered without pressure, it preferably contains more fine silver particles (a) than a pressure-sintered die attachment material from the viewpoint of improving the sinterability. That is, the content of the fine silver particles (a) in the silver particles (A) in a pressureless sintered die attachment material is, from the viewpoint of improving the sinterability, preferably 30 to 65 mass%, more preferably 35 to 60 mass%, still more preferably 40 to 60 mass%, and particularly preferably 45 to 55 mass% in terms of silver based on 100 mass% of the silver particles(A). On the other hand, the content of the fine silver particles (a) in the silver particles (A) in the pressure-sintered die attachment material is, from the viewpoint of cost and from the viewpoint of ensuring the sinterability and suppressing sintering shrinkage, preferably 0 to 50 mass%, more preferably 0 to 30 mass%, still more preferably 0 to 15 mass%, and particularly preferably 0 to 10 mass% in terms of silver based on 100 mass% of the silver particles (A).

### [Solvent (B)]

Solvents known in the art can be used as the solvent (B) used in the conductive composition of the present embodiment. Examples of the solvent include alcohol-based solvents such as ethylene glycol, propylene glycol, benzyl alcohol, 2-ethyl-1,3-hexanediol, and dihydroterpineol, aromatic hydrocarbon-based solvents such as toluene, xylene, ethylbenzene, diethylbenzene, isopropylbenzene, amylbenzene, p-cymene, tetralin, and petroleum-based aromatic hydrocarbon mixtures, terpene alcohols such as terpineol, linalool, geraniol, and citronellol, ether alcohol-based solvents such as ethylene glycol monoethyl ether, ethylene glycol monobutyl ether, propylene glycol monomethyl ether, propylene glycol monoethyl ether, propylene glycol mono-n-butyl ether, ethylene glycol monophenyl ether, propylene glycol mono-tert-butyl ether, diethylene glycol monoethyl ether, diethylene glycol monobutyl ether, dipropylene glycol monomethyl ether, dipropylene glycol monobutyl ether, and tripropylene glycol monomethyl ether, ketone-based solvents such as methyl isobutyl ketone, ester-based solvents such as ethylene glycol monomethyl ether acetate, ethylene glycol monoethyl ether acetate, diethylene glycol monoethyl ether acetate, ethylene glycol monobutyl ether acetate, diethylene glycol monobutyl ether acetate, propylene glycol monomethyl ether acetate, propylene glycol monoethyl ether acetate, dipropylene glycol monoethyl ether acetate, and 2,2,4-trimethyl-1,3-pentanediol 2-methylpropanoate, and water. The solvents can be used alone. Alternatively, two or more of the solvents can be used in combination.

Preferably, the solvent (B) is, for example, an alcoholic solvent having a hydroxyl group and a boiling point of 180°C to 265°C, and preferably 180°C to 250°C. Among them, diethylene glycol monobutyl ether acetate, 2-ethyl-1,3-hexanediol, 2,2,4-trimethyl-1,3-pentanediol 2-methylpropanoate, dihydroterpineol and benzyl alcohol are preferred. Among them, diethylene glycol monobutyl ether acetate, 2-ethyl-1,3-hexanediol, 2,2,4-trimethyl-1,3-pentanediol 2-methylpropanoate (common name: Texanol), and diethylene glycol mono-2-ethylhexyl ether are more preferred.

The content of the solvent (B) in the conductive composition is not particularly limited. The content is preferably 1 to 20 mass%, more preferably 1.5 to 18 mass%, and still more preferably 2 to 15 mass% based on 100 mass% of the conductive composition. When the content of the solvent (B) in the conductive composition is within the above range, the conductive composition has excellent stability. As a result, the conductive composition can be uniformly applied to an adherend. Therefore, the conductive composition is excellent in printability and transferability. In addition, even if the solvent evaporates during sintering of the silver particles (A), voids generated at the bonding portion to the adherend can be suppressed. Therefore, the bonding portion having a desired thickness can be formed.

### [Thermosetting resin (C)]

The thermosetting resin (C) used in the conductive composition of the present embodiment is a thermosetting resin having an easily saponifiable chlorine concentration of 3,000 to 12,000 ppm. Then, the conductive composition of the present embodiment contains 0.1 to 1.5 parts by mass of the thermosetting resin (C) based on 100 parts by mass of the silver particles (A). By containing a predetermined amount of the thermosetting resin (C) having an easily saponifiable chlorine concentration of 3,000 to 12,000 ppm as described above, sufficient die shear strength can be maintained even by sintering at a low temperature or for a short period of time. Note that as will be described below, easily saponifiable chlorine is generated as an impurity in a production process of an epoxy resin. In a process of producing a thermosetting resin such as (meth)acrylate, bismaleimides, phenolic resin, or silicone resin, the easily saponifiable chlorine is not normally generated. However, for the purpose of achieving both sintering at a low temperature or for a short period of time and the die shear strength, the easily saponifiable chlorine may be separately added to thermosetting resins other than the epoxy resin. Note that the conductive composition of the present invention can be mainly used as the sintered die attachment material. Therefore, curing agents and curing accelerators are not essential components. However, it is also possible to add the curing agent as an optional component, for example, for the purpose of reducing an elastic modulus of the conductive composition.

The content of the thermosetting resin (C) in the conductive composition is, as described above, 0.1 to 1.5 parts by mass based on 100 parts by mass of the silver particles (A). The content may be appropriately adjusted according to the level of easily saponifiable chlorine concentration of the thermosetting resin (C). That is, the easily saponifiable chlorine concentration of the thermosetting resin (C) may be in a range of 3,000 to 12,000 ppm. For example, as the thermosetting resin (C), a thermosetting resin containing a relatively high easily saponifiable chlorine concentration within the above concentration range can also be used. In this case, even if the content of the thermosetting resin (C) is set to a relatively small amount, an effective effect on the sinterability can be obtained. On the other hand, as the thermosetting resin (C), a thermosetting resin containing a relatively low easily saponifiable chlorine concentration within the above concentration range can also be used. In this case, compared with a case where a thermosetting resin having a high easily saponifiable chlorine concentration is used, the content of the thermosetting resin can be increased by a small amount to improve the effect on the sinterability.

Examples of thermosetting resins (C) include epoxy resin, (meth)acrylate, bismaleimides, phenolic resin, and silicone resin. However, the thermosetting resin (C) used in the conductive composition of the present embodiment is a thermosetting resin containing easily saponifiable chlorine. As mentioned above, it is necessary that the easily saponifiable chlorine concentration be in the range of 3,000 to 12,000 ppm.

The "easily saponifiable chlorine" refers to a "chlorine species present as 1,2-chlorohydrin that is generated when dehydrochlorination is incomplete". Examples of the easily saponifiable chlorine include 1,2-chlorohydrin form, 1,3-chlorohydrin form, and 1-chloromethyl-2-glycidyl ether form (chloromethyl form). They are usually generated as impurities in the production process of the epoxy resin.

Examples of 1,2-chlorohydrin form include compounds represented by general formula (1). Examples of 1,3-chlorohydrin form include compounds represented by general formula (2). Examples of chloromethyl form include compounds represented by general formula (3). In general formulas (1) to (3) below, R¹, R², R³ and R⁴ are each independently a hydrogen atom or a methyl group. n is an integer of 0 to 30, preferably 0 to 20, and more preferably 0 to 10.

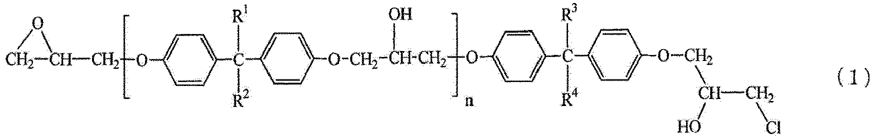

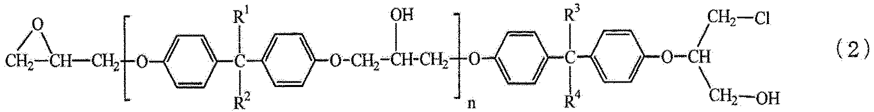

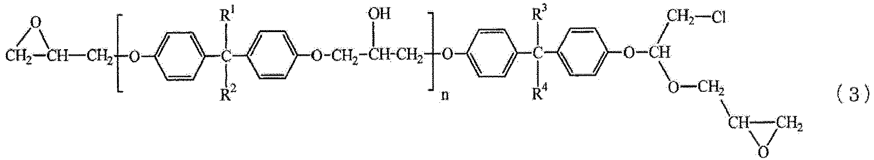

The thermosetting resin (C) preferably contains the epoxy resin. There are no particular restrictions on the choice of the epoxy resin. A known epoxy resin can be used. Examples of the epoxy resin include epoxy resins such as bisphenol A type, bisphenol F type, biphenyl type, tetramethylbiphenyl type, cresol novolak type, phenol novolak type, bisphenol A novolak type, dicyclopentadiene phenol condensation type, phenol aralkyl condensation type, and glycidylamine type, brominated epoxy resins, cycloaliphatic epoxy resins, and aliphatic epoxy resins. These epoxy resins can be used alone. Alternatively, two or more of the epoxy resins can be mixed and used.

Examples of the epoxy resin used as the thermosetting resin (C) are "EPOX-MK R540 (product name)" produced by Printec Corporation, "AK-601 (product name)" produced by Nippon Kayaku Co., Ltd., and "EX-722L (product name)" and "EX-521 (product name)" produced by Nagase ChemteX Corporation. The easily saponifiable chlorine concentration of "EPOX-MK R540" is about 8,000 to 9,000 ppm. The easily saponifiable chlorine concentration of "AK-601" is about 6,000 ppm. The easily saponifiable chlorine concentration of "EX-722L" is about 4,000 ppm. The easily saponifiable chlorine concentration of "EX-521" is about 5,000 to 6,000 ppm. Note that the easily saponifiable chlorine concentration described above is an actual measurement value. A measurement method will be described below. These epoxy resins can be used alone. Alternatively, two or more of the epoxy resins can be mixed and used.

The easily saponifiable chlorine concentration of the thermosetting resin (C) is 3,000 to 12,000 ppm, preferably 5,000 to 12,000 ppm, more preferably 6,000 to 12,000 ppm, still more preferably 7,000 to 12,000 ppm.

In the conductive composition of the present embodiment, a mass ratio of the thermosetting resin (C) is 0.1 to 1.5 parts by mass based on 100 parts by mass of the silver particles (A). The mass ratio of the thermosetting resin (C) is preferably 0.1 to 1.3 parts by mass, more preferably 0.1 to 0.7 parts by mass, and still more preferably 0.1 to 0.4 based on 100 parts by mass of the silver particles (A). Note that when the mass ratio of the thermosetting resin (C) exceeds 1.5 parts by mass based on 100 parts by mass of the silver particles (A), the amount of the thermosetting resin (C) based on the silver particles (A) increases. Therefore, sintering inhibition is likely to occur in some cases. On the other hand, when the mass ratio of the thermosetting resin (C) is less than 0.1 parts by mass based on 100 parts by mass of the silver particles (A), it is difficult to maintain sufficient die shear strength in sintering at a low temperature or for a short period of time.

Methods for measuring the easily saponifiable chlorine concentration of the thermosetting resin (C) include the following method. First, 25 mL of 2-butanone is added to 1 g of the thermosetting resin (C) to be measured. Thus, the thermosetting resin is dissolved. Subsequently, 25 mL of 2-butoxyethanol is further added to the resulting solution. Subsequently, 25 mL of 1 mol/L sodium hydroxide solution is added to the resulting solution, and mixed. Subsequently, the resulting solution is allowed to stand at room temperature of 25°C for 60 minutes. Subsequently, 25 mL of acetic acid is further added to the solution which is allowed to stand for 60 minutes, and mixed. Thus, a sample solution is obtained. Then, the easily saponifiable chlorine concentration is determined by potentiometric titration using a silver electrode immersed in the obtained sample solution, and a 0.01 mol/L silver nitrate solution.

The conductive composition of the present embodiment is printed or applied to a desired portion of a base material or the like by a conventionally known method such as screen printing. Thereafter, a semiconductor element or the like as the component is placed thereon. Subsequently, the bonding portion is formed by heating and firing at a predetermined temperature. Thus, the electronic component can be formed.

The conductive composition of the present embodiment can be used to form a conductive circuit on a printed circuit board, an electrode of a capacitor, and the like. Furthermore, by taking advantage of the above-mentioned characteristics, it can be suitably used, for example, for bonding electronic components such as semiconductor devices to each other, and bonding the component to a substrate.

### [Method for producing conductive composition]

A method for producing the conductive composition of the present embodiment is not particularly limited. In the production method, the components are charged into a mixer such as a planetary stirrer, a dissolver, a bead mill, a grinding machine, a pot mill, a three-roll mill, a rotary mixer, or a twin-screw mixer in a predetermined formulation, and mixed. Thus, the conductive composition of this embodiment can be produced.

### [Die attachment material]

Next, an embodiment of the die attachment material of the present invention will be described. The embodiment of the die attachment material of the present invention is a die attachment material containing the conductive composition described above. The conductive composition contains the silver particles (A) having an average particle size of 0.05 to 5 µm, the solvent (B), and the thermosetting resin (C). The easily saponifiable chlorine concentration of the thermosetting resin (C) is 3,000 to 12,000 ppm. The conductive composition contains 0.1 to 1.5 parts by mass of the thermosetting resin (C) based on 100 parts by mass of the silver particles (A).

The die attachment material of the present embodiment is particularly suitable for use as a die attachment material for the bonding portion of the semiconductor device as the electronic component. Conventionally, lead solder has been widely used as the die attachment material. However, due to harmfulness of lead, many countries are restricting its use more severely. The die attachment material containing the conductive composition of the present invention exhibits thermal conductivity equal to or higher than that of lead (generally 35 to 65 W/mK), and also has good conductivity. Therefore, the die attachment material of the present embodiment is a highly thermally conductive die attachment material that can replace the lead solder. The die attachment material of the present embodiment is suitable as the semiconductor device, for example, as the die attachment material for forming a bonding portion for bonding a silicon die. In addition to the silicon die, various dies such as SiC or GaN can be used.

In the die attachment material of the present embodiment, the silver particles are sintered together even by the heat treatment at a low temperature or for a short period of time regardless of whether the pressure is applied or not in the bonding process, and excellent die shear strength can be achieved. That is, the die attachment material of the present embodiment may be the pressureless sintered die attachment material or the pressure-sintered die attachment material. In the pressureless sintered die attachment material, the silver particles are sintered together only by heating in the bonding process without applying pressure to form the bonding portion. In the pressure-sintered die attachment material, the silver particles are sintered together by heating under pressure to form the bonding portion. The die attachment material can be fired in an inert gas such as a nitrogen atmosphere or in the air. Examples of an apparatus for firing include a known electric furnace, a blow dryer, and a belt furnace.

There are no particular restrictions on bonding conditions without pressure in the bonding process using the die attachment material. For example, a preferred heating temperature for the pressureless sintered die attachment material can be set to 175°C to 280°C. The heating temperature is more preferably 175°C to 250°C, and still more preferably 200°C to 250°C. The heating time can be appropriately changed according to the heating temperature. For example, the heating time can be set to 20 to 120 minutes. A preferred heating time is 20 to 60 minutes.

On the other hand, there are no particular restrictions on bonding conditions under pressure in the bonding process using the die attachment material. For example, a preferred heating temperature for the pressure-sintered die attachment material can be set to 250°C to 310°C. The heating temperature is more preferably 265°C to 310°C, and still more preferably 280°C to 300°C. The heating time can be appropriately changed according to the heating temperature. For example, the heating time can be set to 2 to 10 minutes. A preferred heating time is 2 to 5 minutes. An applied pressure can be set to, for example, 5MPa to 20MPa. A preferred pressure is 8MPa to 15MPa.

In the pressure-sintered die attachment material, preliminary drying (for example, preliminary drying at 120°C for 15 minutes) is performed before main sintering. Therefore, when the thermosetting resin (C) is contained as in the die attachment material of the present embodiment, the thermosetting resin remains without volatilizing during the preliminary drying. Then, in the main sintering, the thermosetting resin exhibits effects of the present invention. Therefore, handleability of the die attachment material is excellent.

### [Electronic component]

Next, an embodiment of the electronic component of the present invention will be described. The embodiment of the electronic component of the present invention is an electronic component having a sintered body of the conductive composition described above. The conductive composition contains the silver particles (A) having an average particle size of 0.05 to 5 µm, the solvent (B), and the thermosetting resin (C). The easily saponifiable chlorine concentration of the thermosetting resin (C) is 3,000 to 12,000 ppm, and the conductive composition contains 0.1 to 1.5 parts by mass of the thermosetting resin (C) based on 100 parts by mass of the silver particles (A). In the electronic component of the present embodiment, the sintered body of the conductive composition forms a bonding portion for bonding the electronic components such as semiconductor devices to each other, or the substrate to the component and the like.

### Examples

Hereinafter, the present invention will be described more specifically with reference to examples. However, the present invention is by no means limited by these examples.

Analyses in the examples were carried out as follows.

### [Average particle size of silver particles and fine silver particles]

The average particle size of the silver particles and fine silver particles is the average value (number average value) of the particle sizes when 200 arbitrary particles are observed with the scanning electron microscope (SEM). S-3400N (manufactured by Hitachi High-Tech Corporation) was used as the scanning electron microscope (SEM).

### (1) Easily saponifiable chlorine concentration of thermosetting resin

By adding 25 mL of 2-butanone to 1 g of the thermosetting resin to be measured, the thermoplastic resin was dissolved. Subsequently, 25 mL of 2-butoxyethanol was further added to the resulting solution. Subsequently, 25 mL of 1 mol/L NaOH solution was added to the resulting solution and mixed. Subsequently, the resulting solution was allowed to stand at room temperature of 25°C for 60 minutes. 25 mL of acetic acid was further added to the solution after standing. Then, a sample solution was obtained by mixing the solution after standing and the acetic acid. The easily saponifiable chlorine concentration (ppm) was measured by potentiometric titration using a silver electrode immersed in the obtained sample solution, and a 0.01 mol/L silver nitrate solution.

### (2) Measurement of conductive composition

### (2-1) Preparation of test piece and pressure bonding conditions

The conductive composition was applied to a region of width 10 mm, length 10 mm, and thickness 150 µm on a silver-plated copper substrate having a thickness of 1 mm. Thereafter, the conductive composition was dried at 120°C for 15 minutes in an air atmosphere. Thereafter, a 3 mm silver plated copper chip was placed on a dried coating film. Subsequently, temperature of a head and a stage of a pressure device was set to 280°C. Thereafter, a test piece was then placed on the stage of the pressure device. Then, pressurization was started immediately. In pressurization, the test piece was pressurized at a constant rate from 0MPa to 8MPa in 10 seconds.

Thereafter, a state of pressure 8MPa was maintained for 3 minutes. After 3 minutes, pressure bonding was completed. Then, the test piece was quickly taken out. All pressure bonding described above was performed in an air atmosphere. Note that among test pieces of Examples and Comparative Examples, pressure-bonded test pieces are indicated as "pressure" in a "pressure/ pressureless" column of Tables 1 to 3.

### (2-2) Preparation of test piece and pressureless bonding conditions

The conductive composition was applied to a region of width 10 mm, length 10 mm, and thickness 150 µm on a silver-plated copper substrate having a thickness of 1 mm. Thereafter, a 3 mm silver plated copper chip was placed on a coating film. Thereafter, a test piece was placed in an oven set at 100°C and left for 30 minutes. After leaving for 30 minutes, the test piece taken out of the oven was quickly put into another oven set at 250°C and left for 20 minutes. Thereafter, the test piece was removed. All pressureless bonding described above was performed in an air atmosphere. Note that among test pieces of Examples and Comparative Examples, pressureless-bonded test pieces are indicated as "pressureless" in a "pressure/ pressureless" column of Tables 1 to 3.

### (2-3) Die shear strength (bonding strength)

The die shear strength of the test piece bonded under the above pressure bonding conditions or the pressureless bonding conditions was measured by a bond tester (universal bond tester series 4000 (product name)) manufactured by Nordson Advanced Technologies.

### (2-4) Evaluation method (Determination)

The test pieces of Examples and Comparative Examples were evaluated according to the following evaluation criteria.
Evaluation "Excellent": The die shear strength is 65MPa or more.
Evaluation "Good": The die shear strength is 50MPa or more and less than 65MPa.
Evaluation "Poor": The die shear strength is less than 50MPa.
Note that in Tables 1 to 3, the evaluation "Excellent" is indicated by "A", the evaluation "Good" is indicated by "B", and the evaluation "Poor" is indicated by "C".

The components used in Examples are as follows.

### <Silver particles (A)>

### (A-1) Spherical silver particles having an average particle size of 0.9 µm

Silver particles (A-1) were produced according to a method for producing the silver particles described in Example 1 of JP-A-2016-033259. As a result of scanning electron microscope (SEM) observation, it was verified that the silver particles had an average particle size of 0.9 µm.

### (A-2) Spherical silver particles having an average particle size of 1.2 µm (K-0082P (product name) manufactured by Metalor Technologies)

### (A-3) Spherical fine silver particles having an average particle size of 0.15 µm

Note that the fine silver particles (A-3) were produced according to a method for producing the fine silver particles described in Example 1 of JP-A-2006-183072. As a result of scanning electron microscope (SEM) observation, it was verified that the average particle size of the fine silver particles was 0.15 µm.

### (A-4) Spherical fine silver particles with an average particle size of 0.4 µm.

Note that the fine silver particles (A-4) were produced according to a method for producing the fine silver particles described in paragraph [0083] of WO 2017/204238 A. As a result of scanning electron microscope (SEM) observation, it was verified that the average particle size of the fine silver particles was 0.4 µm.

### <Solvent (B)>

(B-1) 2-ethyl-1,3-hexanediol (manufactured by FUJIFILM Wako Pure Chemical Corporation)
(B-2) Texanol (manufactured by FUJIFILM Wako Pure Chemical Corporation)

### <Thermosetting resin (C)>

(C-1) Epoxy resin (manufactured by Nagase ChemteX Corporation, EX-722L (product name), easily saponifiable chlorine concentration: 4000 ppm)
(C-2) Epoxy resin (manufactured by Nagase ChemteX Corporation, EX-521 (product name), easily saponifiable chlorine concentration: 6000 ppm)
(C-3) Epoxy resin (manufactured by Printec Corporation, EPOX-MK R540 (product name), easily saponifiable chlorine concentration: 8000 ppm)
(C-4) Epoxy resin (manufactured by Nippon Kayaku Co., Ltd., by-product when producing distilled product of AK-601 (product name), easily saponifiable chlorine concentration: 11000 ppm)
(C-5) Epoxy resin (manufactured by Nagase ChemteX Corporation, EX-722P (product name), easily saponifiable chlorine concentration: 60 ppm)
(C-6) Epoxy resin (manufactured by Nippon Kayaku Co., Ltd., distilled product of AK-601 (product name), easily saponifiable chlorine concentration: 1000 ppm)
(C-7) Acrylate (manufactured by Kyoeisha Chemical Co., Ltd., light acrylate DCP-A (product name))
   Note that the epoxy resin (C-4) is an epoxy resin containing a high concentration of easily saponifiable chlorine component generated as a by-product when AK-601 (product name) is distilled.

Components shown in Tables 1 to 3 were prepared in formulations shown in Tables 1 to 3 for the conductive compositions of Examples and Comparative Examples. Specifically, the components shown in Tables 1 to 3 were uniformized by stirring and defoaming using a rotation or revolution stirrer. Thus, the conductive compositions of Examples and Comparative Examples were prepared. Using the obtained conductive composition, the die shear strength was measured by a test method described above. The measurement results were determined based on the evaluation method described above. Note that the unit of formulation shown in Tables 1 to 3 is parts by mass. The results are shown in Tables 1 to 3.

**[Table 1]**

| | Example 1 | Example 2 | Example 3 | Example 4 | Example 5 | Example 6 | Example 7 | Example 8 |
|---|---|---|---|---|---|---|---|---|
| (A-1) Silver particles (0.9 µm) (spherical) | 100.00 | 95.00 | 95.00 | 95.00 | 95.00 | 95.00 | 95.00 | 95.00 |
| (A-2) Silver particles (1.2 µm) (spherical) | - | - | - | - | - | - | - | - |
| (A-3) Fine silver particles (0.15 µm) (spherical) | - | 5.00 | 5.00 | 5.00 | 5.00 | 5.00 | 5.00 | 5.00 |
| (A-4) Fine silver particles (0.40 µm) (spherical) | - | - | - | - | - | - | - | - |
| (B-1) Solvent (2-ethyl-1,3-hexanediol) | 8.00 | 8.00 | 8.00 | 8.00 | 8.00 | 8.00 | 8.00 | 8.00 |
| (B-2) Solvent (Texanol) | - | - | - | - | - | - | - | - |
| (C-1) Epoxy resin (easily saponifiable chlorine concentration: 4000 ppm) | - | - | - | - | - | - | 0.15 | 0.6 |
| (C-2) Epoxy resin (easily saponifiable chlorine concentration: 6000 ppm) | - | - | - | - | - | 0.30 | - | - |
| (C-3) Epoxy resin (easily saponifiable chlorine concentration: 8000 ppm) | 0.30 | 0.30 | 0.15 | 0.60 | 1.40 | - | - | - |
| (C-4) Epoxy resin (easily saponifiable chlorine concentration: 11000 ppm) | - | - | - | - | - | - | - | - |
| (C-5) Epoxy resin (easily saponifiable chlorine concentration: 60 ppm) | - | - | - | - | - | - | - | - |
| (C-6) Epoxy resin (easily saponifiable chlorine concentration: 1000 ppm) | - | - | - | - | - | - | - | - |
| (C-7) Acrylate resin | - | - | - | - | - | - | - | - |
| Pressure/Pressureless | Pressure | Pressure | Pressure | Pressure | Pressure | Pressure | Pressure | Pressure |
| Die shear strength (MPa) | 63 | 68 | 50 | 72 | 53 | 58 | 53 | 61 |
| Evaluation | B | A | B | A | B | B | B | B |

**[Table 2]**

| | Example 9 | Example 10 | Example 11 | Example 12 | Example 13 | Example 14 | Example 15 | Example 16 |
|---|---|---|---|---|---|---|---|---|
| (A-1) Silver particles (0.9 µm) (spherical) | 95.00 | 95.00 | 100.00 | - | 95.00 | 95.00 | 50.00 | 95.00 |
| (A-2) Silver particles (1.2 µm) (spherical) | - | - | - | 95.00 | - | - | - | - |
| (A-3) Fine silver particles (0.15 µm) (spherical) | 5.00 | - | - | 5.00 | 5.00 | 5.00 | 50.00 | 5.00 |
| (A-4) Fine silver particles (0.40 µm) (spherical) | - | 5.00 | - | - | - | - | - | - |
| (B-1) Solvent (2-ethyl-1,3-hexanediol) | 8.00 | 8.00 | - | 8.00 | 8.00 | 8.00 | 8.00 | 8.00 |
| (B-2) Solvent (Texanol) | - | - | 8.00 | - | - | - | - | - |
| (C-1) Epoxy resin (easily saponifiable chlorine concentration: 4000 ppm) | 1.40 | - | - | - | - | - | - | - |
| (C-2) Epoxy resin (easily saponifiable chlorine concentration: 6000 ppm) | - | - | - | - | - | - | - | - |
| (C-3) Epoxy resin (easily saponifiable chlorine concentration: 8000 ppm) | - | 0.30 | 0.30 | 0.30 | 0.30 | 0.30 | 0.30 | - |
| (C-4) Epoxy resin (easily saponifiable chlorine concentration: 11000 ppm) | - | - | - | - | - | - | - | 0.15 |
| (C-5) Epoxy resin (easily saponifiable chlorine concentration: 60 ppm) | - | - | - | - | - | - | - | - |
| (C-6) Epoxy resin (easily saponifiable chlorine concentration: 1000 ppm) | - | - | - | - | - | 0.30 | - | 0.15 |
| (C-7) Acrylate resin | - | - | - | - | 0.30 | - | - | - |
| Pressure/Pressureless | Pressure | Pressure | Pressure | Pressure | Pressure | Pressure | Pressureless | Pressure |
| Die shear strength (MPa) | 52 | 55 | 60 | 52 | 53 | 57 | 58 | 56 |
| Evaluation | B | B | B | B | B | B | B | B |

**[Table 3]**

| | Comparative Example 1 | Comparative Example 2 | Comparative Example 3 | Comparative Example 4 | Comparative Example 5 | Comparative Example 6 | Comparative Example 7 | Comparative Example 8 | Comparative Example 9 |
|---|---|---|---|---|---|---|---|---|---|
| (A-1) Silver particles (0.9 µm) (spherical) | 95.00 | 95.00 | 95.00 | 95.00 | 95.00 | 95.00 | 95.00 | 50.00 | *50.00* |
| (A-2) Silver particles (1.2 µm) (spherical) | - | - | - | - | - | - | - | - | - |
| (A-3) Fine silver particles (0.15 µm) (spherical) | 5.00 | 5.00 | 5.00 | 5.00 | 5.00 | 5.00 | 5.00 | 50.00 | 50.00 |
| (A-4) Fine silver particles (0.40 µm) (spherical) | - | - | - | - | - | - | - | - | - |
| (B-1) Solvent (2-ethyl-1,3-hexanediol) | 8.00 | 8.00 | 8.00 | 8.00 | 8.00 | 8.00 | 8.00 | 8.00 | 8.00 |
| (B-2) Solvent (Texanol) | - | - | - | - | - | - | - | - | - |
| (C-1) Epoxy resin (easily saponifiable chlorine concentration: 4000 ppm) | - | - | - | - | - | - | - | - | - |
| (C-2) Epoxy resin (easily saponifiable chlorine concentration: 6000 ppm) | - | - | - | - | - | - | - | - | - |
| (C-3) Epoxy resin (easily saponifiable chlorine concentration: 8000 ppm) | - | - | - | - | 0.05 | 2.00 | - | - | 2.00 |
| (C-4) Epoxy resin (easily saponifiable chlorine concentration: 11000 ppm) | - | - | - | - | - | - | - | - | - |
| (C-5) Epoxy resin (easily saponifiable chlorine concentration: 60 ppm) | 0.30 | 1.40 | - | - | - | - | - | - | - |
| (C-6) Epoxy resin (easily saponifiable chlorine concentration: 1000 ppm) | - | - | 0.30 | 1.40 | - | - | - | - | - |
| (C-7) Acrylate resin | - | - | - | - | - | - | 0.30 | 0.30 | - |
| Pressure/Pressureless | Pressure | Pressure | Pressure | Pressure | Pressure | Pressure | Pressure | Pressureless | Pressure less |
| Die shear strength (MPa) | 31 | 21 | 38 | 24 | 42 | 45 | 38 | 38 | 45 |
| Evaluation | C | C | C | C | C | C | C | C | C |

As shown in Tables 1 and 2, the bonding portions formed using the conductive compositions of Examples 1 to 16 had a die shear strength (bonding strength) of 50MPa or more. That is, these conductive compositions have excellent die shear strength. In addition, the conductive compositions of Examples 1 to 16 have excellent die shear strength even when the bonding portions are formed by pressure bonding as in Examples 1 to 14 and 16, and even when the bonding portions are formed by pressureless bonding as in Example 15. In particular, the bonding portion formed using the conductive composition of Example 4 has particularly excellent die shear strength. It was verified that the die shear strength (bonding strength) tends to gradually decrease when the easily saponifiable chlorine concentration of the thermosetting resin (C) decreases or increases as compared to the conductive composition of Example 4.

Further, when comparing the die shear strengths of the bonding portions formed using the conductive compositions of Examples 1 and 2, the bonding portion formed using the conductive composition of Example 2 containing the fine silver particles (A-3) showed a higher value. Therefore, it was found that the die shear strength of the bonding portion was increased by containing fine silver particles having a number average particle size of submicron order.

Further, even when two types of epoxy resins are used in combination as in the conductive composition of Example 16, it was found that the die shear strength of the bonding portion was increased by adjusting the easily saponifiable chlorine concentration so as to satisfy a desired numerical range. In the conductive composition of Example 13, as the thermosetting resin (C), the epoxy resin (C-3) having an easily saponifiable chlorine concentration of 8000 ppm and the acrylate (C-7) substantially containing no easily saponifiable chlorine are used in combination. It was found that the die shear strength of the bonding portion of such a conductive composition was also increased.

On the other hand, in the conductive compositions of Comparative Examples 1 to 4, 7, and 8, the easily saponifiable chlorine concentration of the thermosetting resin (C) is low. Alternatively, the conductive composition does not substantially contain easily saponifiable chlorine. As a result, the die shear strength of the bonding portion is low. In the conductive composition of Comparative Example 5, a blending amount of the epoxy resin (C-3) as the thermosetting resin (C) is small. Therefore, the die shear strength of the bonding portion is low. Further, in the conductive compositions of Comparative Examples 6 and 9, the blending amount of the epoxy resin (C-3) as the thermosetting resin (C) is high. As a result, the die shear strength of the bonding portion is low.

### INDUSTRIAL APPLICABILITY

The conductive composition of the present invention can be used for adhesion of the members in the semiconductor devices, the electric components, and the electronic components, for example as the die attachment material. Further, the die attachment material and pressure-sintered die attachment material of the present invention are the die attachment materials containing the conductive composition of the present invention. As described above, the conductive composition of the present invention can be used for adhering the members in the semiconductor devices, the electric components, and the electronic components. The electronic component of the present invention can be used in the semiconductor devices, electrical fields, and electronic fields.

## Claims

1. A conductive composition comprising silver particles (A) having an average particle size of 0.05 to 5 µm, a solvent (B), and a thermosetting resin (C), wherein
easily saponifiable chlorine concentration of the thermosetting resin (C) is 3,000 to 12,000 ppm, and
the conductive composition contains 0.1 to 1.5 parts by mass of the thermosetting resin (C) based on 100 parts by mass of the silver particles (A).

2. The conductive composition according to claim 1, wherein the thermosetting resin (C) contains an epoxy resin.

3. The conductive composition according to claim 1 or 2, wherein the silver particles (A) contain fine silver particles having an average particle size of 0.05 to 0.5 µm.

4. A die attachment material comprising the conductive composition according to any one of claims 1 to 3.

5. A pressure-sintered die attachment material comprising the conductive composition according to any one of claims 1 to 3.

6. An electronic component comprising a sintered body of the conductive composition according to any one of claims 1 to 3.
